**Europäisches Patentamt**

**European Patent Office**

**Office européen des brevets**

(19)

(11) Veröffentlichungsnummer : **0 334 142 B1**

(12) # EUROPÄISCHE PATENTSCHRIFT

(45) Veröffentlichungstag der Patentschrift :
**20.05.92 Patentblatt 92/21**

(51) Int. Cl.⁵ : **B64G 1/50,** F28D 15/02,
F25B 39/02, H05K 7/20

(21) Anmeldenummer : **89104355.6**

(22) Anmeldetag : **11.03.89**

(54) **Verdampfereinheit.**

(30) Priorität : **25.03.88 DE 3810128**

(43) Veröffentlichungstag der Anmeldung :
**27.09.89 Patentblatt 89/39**

(45) Bekanntmachung des Hinweises auf die
Patenterteilung :
**20.05.92 Patentblatt 92/21**

(84) Benannte Vertragsstaaten :
**FR IT**

(56) Entgegenhaltungen :
**EP-A- 0 210 337**
**EP-A- 0 242 669**
**FR-A- 2 380 520**
**US-A- 4 765 396**

(73) Patentinhaber : **ERNO Raumfahrttechnik
Gesellschaft mit beschränkter Haftung
Hünefeldstrasse 1-5
W-2800 Bremen 1 (DE)**

(72) Erfinder : **Müller, Robert
Am Hexendeich 16
W-2805 Moordeich (DE)**

EP 0 334 142 B1

Jouve, 18, rue Saint-Denis, 75001 PARIS

## Beschreibung

Die Erfindung betrifft eine Vorrichtung zum Überführen eines Arbeitsfluids aus dem flüssigen in den dampfförmigen Zustand, insbesondere für Anlagen zur Ableitung von Abfallwärme in Raumflugkörpern, in Form einer Verdampfereinheit, die aus wenigstens einem Verdampferelement besteht, bei dem ein Flüssigkeits- und ein Dampfraum durch ein kapillar aufgebautes Trennelement voneinander separiert sind und der Dampfraum die Form von Primärkanälen aufweist, die entlang eines rohrförmig ausgebildeten Trennelementes angeordnet sind.

Derartige Verdampfereinheiten, die auch als Kapillarverdampfer bezeichnet werden, sind bereits gemäß der EP-A-0 210 337 bekannt. Ihre Verwendung ist insbesondere für den Bereich der Raumfahrttechnik, z.B. für Weltraumplattformen und wiederverwendbare Transportsysteme, vorgesehen. Bei der bekannten Anordnung erfolgt die Zufuhr eines flüssigen Mediums axial durch ein Innenrohr als Trennelement und radial durch eine Perforation in das kapillar aufgebaute Trennelement. Von dieser strömt das Medium unter Zufuhr des Wärmestromes dampfförmig in darüberliegende Dampfkanäle, von wo es über ein Sammelrohr an eine Wärmesenke abgeleitet wird.

Derartige Anordnungen sind erforderlich, da in allen Raumflugkörpern durch Energieumwandlungen bei Antrieb, Steuerung, Signalverarbeitung, Experimenten und metabolischen Prozessen aufgrund des beschränkten thermodynamischen Wirkungsgrades der verwendeten Systeme Abfallwärme entsteht. Diese muß, um eine unerwünschte Aufheizung des Raumflugkörpers zu verhindern, innerhalb des Flugkörpers vom Ort ihrer Entstehung abtransportiert und an einer dafür geeigneten Stelle an die Umgebung abgeführt werden.

Sowohl der Transport der Wärme zwischen einer Wärmequelle und einer im Abstand von dieser befindlichen Wärmesenke mittels eines geschlossenen Fluidkreislaufs als auch die unmittelbare Wärmeabgabe durch in die Umgebung verdampfendes Arbeitsfluid führen zur gewünschten Temperaturkontrolle. Dabei erscheinen die sogenannten Transportsysteme vor allem für größere Orbitalstationen geeignet, während die sogenannten Abgabesysteme eher bei Raumtransportern zum Einsatz kommen.

Beiden Systemen zur Wärmeabfuhr gemeinsam ist die Verwendung einer Verdampfereinheit, für deren einwandfreien Betrieb zwei Voraussetzungen erfüllt sein müssen: Zum einen müssen die Heizflächen stets mit dem zu verdampfenden Arbeitsfluid, beispielsweise Wasser oder Ammoniak, benetzt sein, und zum anderen muß eine wirksame Trennung der flüssigen und der dampfförmigen Phase gewährleistet sein.

Während diese Aufgaben in terrestrischen Anlagen von der Schwerkraft erfüllt werden, fehlt bei den beschriebenen Einsatzbereichen eine äußere Beschleunigungskraft entweder ganz, wie im Fall der Orbitalstationen, oder sie wechselt in Betrag und Richtung, wie im Fall der Weltraumtransportsysteme. Aus diesem Grund finden bei Raumflugkörpern unter anderem Verdampfersysteme Verwendung, die nach dem Kapillarprinzip arbeiten, d.h. bei dem kapillarförmig aufgebaute Elemente quasi als Docht wirken. In derartigen Verdampfern werden Flüssigkeit und Dampf durch die Kapillarstruktur eines Trennelementes voneinander getrennt, und die Wärme wird durch eine spezielle Rippenanordnung durch den Dampfraum zur dampfseitigen Oberfläche der als Docht wirkenden Kapillarstruktur geleitet. Durch die Kapillarkräfte ist dabei der Docht ständig mit dem Arbeitsfluid getränkt, zugleich bewirken diese Kapillarkräfte, daß sich der zur Kühlung erforderliche Massenstrom des Arbeitsfluids selbsttätig einstellt.

Aufgabe der Erfindung ist es, eine Verdampfereinheit der eingangs genannten Art so auszubilden, daß sie eine optimale Wärmeabfuhr gewährleistet und dabei zugleich ein geringes Bauvolumen und ein ebenfalls geringes Gewicht aufweist.

Diese Aufgabe löst die Erfindung dadurch, daß in der dem Trennelement zugewandten Oberfläche der den Dampfraum begrenzenden Wandflächen Sekundärkanäle angeordnet sind, die mit den Primärkanälen in Verbindung stehen und die in etwa senkrecht zu diesen verlaufen.

Der Vorteil dieser Vorrichtung besteht dabei zugleich noch darin, daß durch die als Folge der erfindungsgemäßen Ausbildung erreichte Maximierung der Heizfläche ein sehr großer Wärmeübergangskoeffizient erzielt wird. Ferner ergibt sich ein niedriger dampfseitiger Druckverlust und deshalb eine in bezug auf die axiale Richtung weitgehend konstante Verdampfungstemperatur.

Die in den weiteren Ansprüchen angegebenen konstruktiven Maßnahmen dienen vor allem dem Zweck, den Wirkungsgrad der erfindungsgemäßen Vorrichtung noch weiter zu steigern. Besonders vorteilhaft ist es dabei, wenn eine Verdampfereinheit als parallele Anordnung einer größeren Zahl rohrförmiger Verdampferelemente aufgebaut ist. Für einen anderen Einsatzzweck, insbesondere in Orbitalstationen, ist es dagegen besonders günstig, wenn die rohrförmigen Verdampferelemente in eine Platte integriert sind, die als Wärmetauscherplatte in einem geschlossenen Zweiphasenkreislauf eingesetzt werden kann.

Insgesamt kann die Vorrichtung gemäß der Erfindung dabei sowohl in einem geschlossenen Kreislauf, beispielsweise in Orbitalplattformen, als auch in sogenannten offenen Kreisläufen verwendet werden, die vor allem für Pendeltransporter geeignet sind.

Im folgendem soll die Erfindung anhand der Zeichnung näher erläutert werden. Es zeigen:

Fig. 1 Prinzipskizzen zweier verschiedener Anlagen zur Abfuhr von Abfallwärme in Raumflugkörpern,

Fig. 2 einen Längsschnitt durch eine Verdampfereinheit,

Fig. 3 einen Schnitt gemäß der Linie III-III durch die in Fig. 2 dargestellte Anordnung,

Fig. 4 eine vergrößerte Detaildarstellung der Anordnung gemäß Fig. 3,

Fig. 5 einen nochmals vergrößerten Ausschnitt aus der in Fig. 4 dargestellten Anordnung,

Fig. 6 einen vergrößerten Schnitt gemäß der Linie VI-VI durch die Anordnung gemäß Fig. 5 in einer um 90° gedrehten Darstellung und

Fig. 7 eine plattenförmige Verdampfereinheit.

In den Figuren sind gleiche Bauteile mit den gleichen Bezugszeichen versehen.

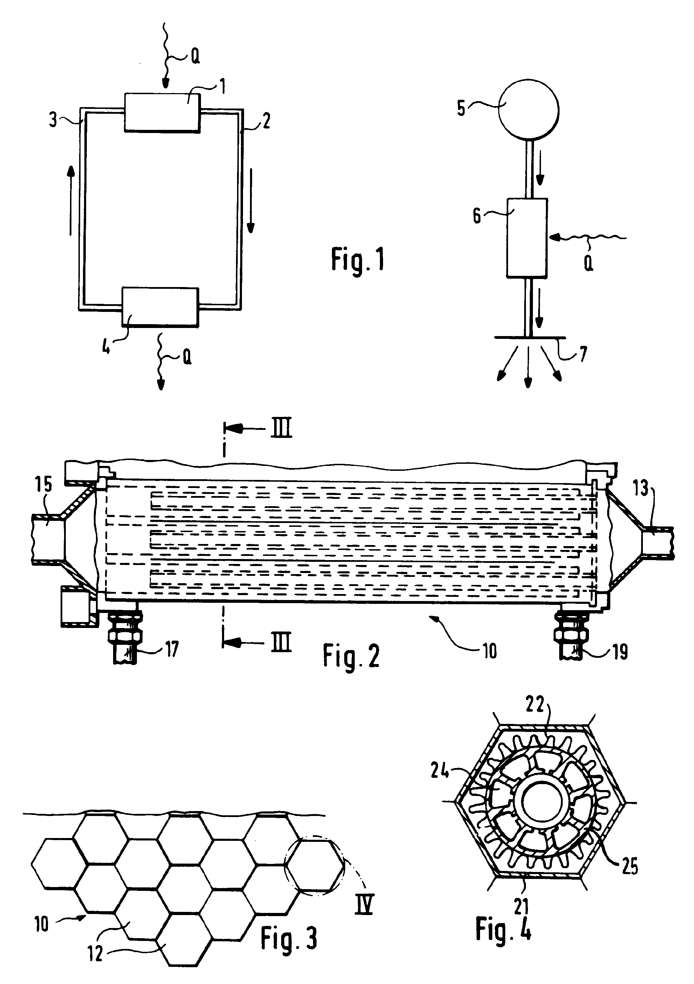

Die Darstellungen in Fig. 1 zeigen den prinzipiellen Aufbau zweier Anlagen zur Abfuhr von Abfallwärme, wie sie in unterschiedlichen Raumflugkörpern verwendet werden und die jeweils eine sogenannte Kapillarverdampfereinheit enthalten. Bei der im linken Teil der Figur dargestellten Anordnung handelt es sich um einen sogenannten geschlossenen Kreislauf, bei dem die Abfallwärme mittels Wärmetransports abgeführt wird.

Bei dieser Anlage wird die von einer im oberen Teil des Bildes befindlichen Wärmequelle stammende Abfallwärme der Verdampfereinheit 1 zugeführt, wo sie ein in einem geschlossenen Rohrsystem 2,3 zirkulierendes Arbeitsfluid in den dampfförmigen Aggregatzustand überführt. Dieser Dampf gelangt über das Rohr 2 zu einem Kondensator 4, in dem der Dampf kondensiert und die in ihm enthaltene Energie in Form von Kondensationswärme an die Umgebung bzw. an eine Wärmesenke abgibt.

Anschließend wird das nunmehr kondensierte Arbeitsfluid über das Rohr 3 zur Verdampfereinheit 1 zurückgeleitet. Die in der Verdampfereinheit enthaltene Kapillarstruktur fungiert bei diesem System quasi als Pumpe für das Arbeitsfluid.

Demgegenüber wird bei der im rechten Teil der Fig. 1 dargestellten Anlage, die einen sogenannten offenen Kreislauf bildet, das Arbeitsfluid ständig aus einem Vorratsbehälter 5 an die Verdampfereinheit 6 nachgeliefert, wo dieses Fluid durch die abzuführende Abfallwärme in Dampf umgewandelt und über eine entsprechende Auslaßöffnung 7 als Dampf an die Umgebung abgegeben wird. In diesem Fall wirkt die in der Verdampfereinheit 6 angeordnete Kapillarstruktur quasi als Rückhaltemembran.

Die in den Figuren 2 und 3 dargestellte Verdampferanlage besteht aus einer Verdampfereinheit 10, bei denen es sich jeweils um eine Parallelanordnung einer größeren Anzahl einzelner Verdampferelemente 12 handelt. Letztere weisen jeweils einen sechseckigen querschnitt auf und sind in der größtmöglichen Packungsdichte angeordnet. Wie aus Fig. 2 ersichtlich, weist jede Verdampfereinheit 10 eine gemeinsame Eintrittsöffnung 13 für das Arbeitsfluid, in diesem Fall Wasser, sowie eine gemeinsame Auslaßöffnung 15 für den in den Verdampferelementen 12 erzeugten Dampf auf. Die Abfallwärme wird im Fall des hier dargestellten Ausführungsbeispiels mittels eines zweiten Arbeitsfluids zugeführt, das über Eintrittsöffnungen 17 in die Verdampfereinheit 10 geleitet wird und diese über Austrittsöffnungen 19 wieder verläßt.

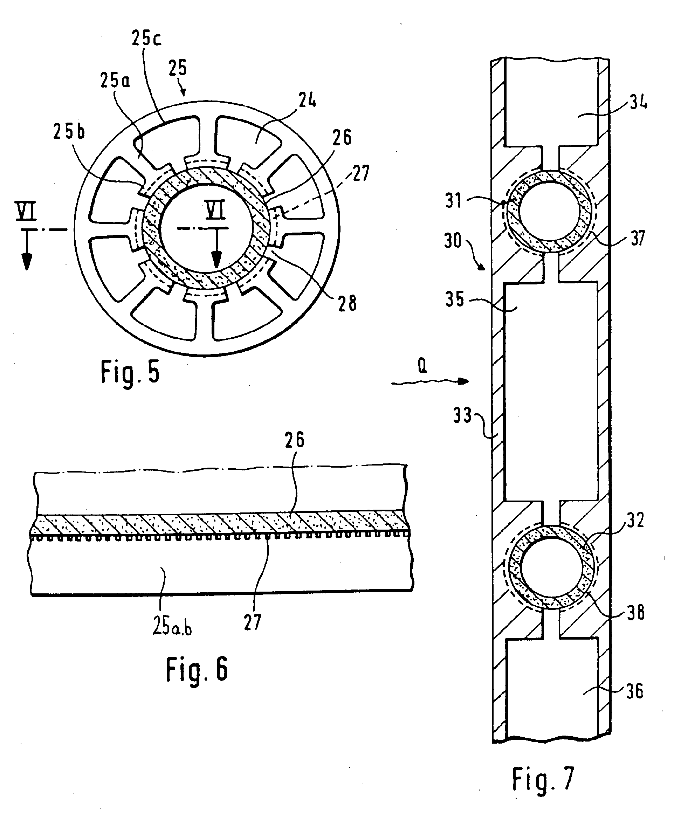

Der Aufbau der Verdampferelemente 12 ist in Fig. 4 im querschnitt dargestellt. Zwischen dem sechseckigen Außenrohr 21 und dem Innenrohr 25 befindet sich ein konzentrischer Ringspalt, der mit Rippen 22 versehen ist, welche ihrerseits an der Außenseite von Innenrohr 25 anliegen. Jedes der Innenrohre 25 ist, in Fig. 5 dargestellt, mit in axialer Richtung verlaufenden Stegen 25a versehen, zwischen welchen sich dann die Primär-Dampfkanäle 24 befinden, die durch Wandsegmente 25c begrenzt werden. Die einzelnen Stege 25a münden jeweils in Rohrsegmente 25b, welche koaxial auf einem Kapillarrohr 26 angeordnet sind, mit welchem sie durch Aufschrumpfen in innigem thermischem Kontakt stehen. Die innere Oberfläche der Rohrsegmente 25b ist wiederum mit Sekundärkanälen 27 versehen, deren Querschnitt erheblich geringer als derjenige der Primärkanäle 24 ist und die spiralförmig auf der Außenseite des Kapillarrohrs 26 verlaufen. Wie ersichtlich ist, sind die Sekundärkanäle 27 jeweils nur bereichsweise ausgebildet und stehen in denjenigen Bereichen 28, in denen die Primärkanäle 24 bis unmittelbar an das Kapillarrohr 26 heranreichen, mit diesen in direkter Verbindung.

Das Kapillarrohr 26 besteht aus einem gesinterten Werkstoff. In seinem Innern befindet sich das eigentliche Arbeitsfluid, das infolge der wirksamen Kapillarkräfte ständig die als Docht fungierende Wandung des Kapillarrohrs 26 benetzt.

Die mittels der Verdampferelemente 12 abzuführende Abfallwärme wird im Fall des hier dargestellten Ausführungsbeispiels, wie bereits erwähnt, mittels eines zweiten Arbeitsfluids zugeführt, das zwischen dem Außenrohr 21 und dem rippenförmigen Verdampferrohrprofil 22 durch jedes Verdampferelement 12 strömt. Der unmittelbar bei Austritt des ersten Arbeitsfluids aus dem Kapillarrohr 26 entstehende Dampf wird über die vergleichsweise feinen Sekundärkanäle 27 zu den Primärkanälen 24 geleitet, von wo er zum Austritt des Verdampferelements 12 und in die gemeinsame Auslaßöffnung 15 strömt.

Bei dem in Fig. 7 dargestellten zweiten Ausführungsbeispiels ist eine Verdampfereinheit 30 als Wärmetauscherplatte ausgebildet. In diesem Fall sind mehrere Kapillarrohre 31,32 parallel zueinander im Innern eines plattenförmigen Bauteils 33 angeordnet, wobei zwischen je zwei Kapillarrohren 31,32 jeweils ein Primärkanal 34 bis 36 verläuft. Jeder der Primärkanäle 34 bis 36 weist an seinen den Kapillarrohren 31,32 zugewandten Schmalseiten jeweils Bereiche auf, die in ihrem Querschnitt verjüngt sind und die unmittelbar bis an das jeweilige Kapillarrohr 31,32 heranreichen. Zusätzlich zu den Primärkanälen 34 bis 36 ist auch in diesem Fall jedes kapillarrohr 31,32 von spiralförmig verlaufenden Sekundärkanälen 37 bzw. 38 umgeben. Diese sind in die an die Kapillarrohre 31 bzw. 32 angrenzenden Bereiche der Wandungen der Primärkanäle 34 bis 36 eingearbeitet und münden jeweils in die querschnittsverjüngten Bereiche der Primärkanäle 34 bis 36, die unmittelbar an die Kapillarrohre 31 bzw. 32 heranreichen.

Die Wirkungsweise dieser Anordnung entspricht dabei derjenigen der vorangehend beschriebenen. Im Unterschied dazu wird in diesem Fall die abzuführende Abfallwärme ohne die Zwischenschaltung eines zweiten Arbeitsfluids unmittelbar an die Außenwand des plattenförmigen Bauteils 33 herangeführt.

Während die zunächst beschriebene Anordnung mit den beiden Verdampfereinheiten 10 in erster Linie für einen offenen Kreislauf vorgesehen ist, ist die zuletzt beschriebene Anordnung besonders für Anlagen mit geschlossenen Zweiphasenkreisläufen, also beispielsweise für Orbitalplattformen, geeignet.

Bezugszeichenliste

| | |
|---|---|
| 1,6 | Verdampfereinheit |
| 2,3 | Rohr |
| 4 | Kondensator |
| 5 | Vorratsbehälter |
| 7 | Auslaßöffnung |
| 8 | ./. |
| 9 | ./. |
| 10 | Verdampfereinheit |
| 12 | Verdampferelemente |
| 13 | Eintrittsöffnung (Arbeitsfluid 1) |
| 15 | Auslaßöffnung (Arbeitsfluid 1) |
| 17 | Eintrittsöffnung (Arbeitsfluid 2) |
| 19 | Auslaßöffnung (Arbeitsfluid 2) |
| 21 | Außenrohr |
| 22 | Verdampferrohrprofil (rippenförmig) |
| 24 | Primärkanäle |
| 25 | Innenrohr |
| 25a | Wärmeleitstege |
| 25b | Rohrsegmente |
| 25c | Wandsegmente |
| 26 | Kapillarrohr |
| 27 | Sekundärkanäle |
| 28 | offene Bereiche |
| 29 | ./. |
| 30 | Verdampfereinheit |
| 31,32 | Kapillarrohr |
| 33 | plattenförmiges Bauteil |
| 34-36 | Primärkanäle |
| 37,38 | Sekundärkanäle |

**Patentansprüche**

1. Vorrichtung zum Überführen eines Arbeitsfluids aus dem flüssigen in den dampfförmigen Zustand, insbesondere für Anlagen zur Ableiten von Abfallwärme in Raumflugkörpern, in Form einer Verdampfereinheit (1), die aus wenigstens einem Verdampferelement besteht, bei dem ein Flüssigkeits- und ein Dampfraum durch ein kapillar aufgebautes Trennelement voneinander separiert sind und der Dampfraum die Form von Primärkanälen (24,34-36) aufweist, die entlang eines rohrförmig ausgebildeten Trennelementes (26,31,32) angeordnet sind, dadurch gekennzeichnet, daß in der dem Trennelement (26,31,32) zugewandten Oberfläche der den Dampfraum begrenzten Wandflächen (25b) Sekundärkanäle (27,37,38) angeordnet sind, die mit den Primärkanälen (24,34-36) in Verbindung stehen und in etwa senkrecht zu diesen verlaufen.

2. Vorrichtung nach Anspruch 1, dadurch gekennzeichnet, daß die Sekundärkanäle (27,37,38) spiralförmig verlaufen.

3. Vorrichtung nach Anspruch 1 oder 2, dadurch gekennzeichnet, daß die Primärkanäle (24) begrenzt werden von Stegen (25a), Rohrsegmenten (25b) und rohrförmigen Wandsegmenten (25c), wobei diese letzten zusammen einen das Trennelement (26) konzentrisch umgebenden Innenrohr (25) bilden.

4. Vorrichtung nach Anspruch 3, dadurch gekennzeichnet, daß auf der Außenfläche des Innenrohrs (25) ein rippenförmiges Profilrohr (22) angeordnet ist.

5. Vorrichtung nach Anspruch 4, dadurch gekennzeichnet, daß das Profilrohr (22) von einem im Abstand zu diesem angeordneten Außenrohr (21) umgeben ist und daß der Raum zwischen dem Außenrohr (21) und dem Profilrohr (22) mit einem zweiten Arbeitsfluid gefüllt ist.

6. Vorrichtung nach Anspruch 5, dadurch gekennzeichnet, daß das Außenrohr (21) einen sechseckförmigen Querschnitt aufweist.

7. Vorrichtung nach Anspruch 6, dadurch gekennzeichnet, daß mehrere Verdampferelemente (12) zu einer Verdampfereinheit (10) zusammengefaßt sind, die mit zu allen Verdampferelementen (12) führenden gemeinsamen Eintritts- (13,17) und Auslaßöffnungen (15,19) für das erste verdampfende (13,15) und zweite Arbeitsfluid (17,19) versehen ist.

8. Vorrichtung nach Anspruch 1 oder 2, dadurch gekennzeichnet, daß wenigstens zwei Verdampferelemente zu einer plattenförmigen Verdampfereinheit (30) zusammengefaßt sind.

9. Vorrichtung nach Anspruch 1 oder 2, dadurch gekennzeichnet, daß das kapillare Trennelement (26,31,32) aus einem metallischen Werkstoff zur Erzielung einer kapillaren Pumpwirkung gebildet ist.

10. Vorrichtung nach Anspruch 1 oder 2, dadurch gekennzeichnet, daß das kapillare Trennelement (26,31,32) aus einem Kunststoff, wie PTFE, zur Bildung einer kapillaren Rückhaltekraft besteht.

11. Vorrichtung nach Anspruch 1 oder 2, dadurch gekennzeichnet, daß das kapillare Trennelement (26,31,32) dampfseitig mit einem Kunststoff, wie PTFE, zur Schaffung einer kapillaren Rückhaltekraft beschichtet ist.

## Claims

1. A device for the conversion of a working fluid from the liquid into the vapour condition, especially for plants for the removal of waste heat in space vehicles, in the form of an evaporation unit (1), which comprises at least one evaporation element, in which a liquid- and a vapour-chamber are separated from each other by means of a separating element with a capillary structure and the vapour chamber has the form of primary channels (24, 34 - 36), which are arranged along a tubular separating element (26, 31, 32) characterised in that in the surface of the wall (25b) defining the vapour-chamber, which surface faces the separating element (26, 31, 32), there are arranged secondary channels (27, 37, 38), which are connected to the primary channels (24, 34 - 36) and run substantially perpendicular thereto.

2. A device according to claim 1, characterised in that the secondary channels (27, 37, 38) are spiral.

3. A device according to claim 1 or 2, characterised in that the primary channels (24) are defined by crosspieces (25a), tubular segments (26b) and tubular wall segments (25c), the last-mentioned together forming an inner tube concentrically surrounding the separating element (26),

4. A device according to claim 3, characterised in that on the outer surface of the inner tube (25) there is provided a sectioned tube with fins.

5. A device according to claim 4, characterised in that the sectioned tube (22) is surrounded by an outer tube (21) arranged at a spacing therefrom, and that the space between the outer tube (21) and the sectioned tube (22) is filled with a second working fluid.

6. A device according to claim 5, characterised in that the outer tube (21) has a hexagonal cross-section.

7. A device according to claim 6, characterised in that a plurality of evaporation elements (12) combine to form an evaporation unit (10) which is provided with common inlet- (13,17) and outlet-openings (15, 19) for the first evaporating (13, 15) and second working fluid (17, 19), which openings lead to all evaporation elements (12).

8. A device according to claim 1 or 2, characterised in that at least two evaporation elements together form a plate-like evaporation unit (30).

9. A device according to claim 1 or 2, characterised in that the capillary separation element (26, 31, 32) is constructed from a metallic material to achieve a capillary pump effect.

10. A device according to claim 1 or 2, characterised in that the capillary separating element (26, 31, 32) comprises a plastics material, such as PTFE, to produce a capillary retaining force.

11. A device according to claim 1 or 2, characterised in that the capillary separating element (26, 31, 32) is coated at the vapour side with a plastics material, such as PTFE, to create a capillary retaining force.

## Revendications

1. Dispositif pour faire passer un fluide de travail d'un état liquide à un état de vapeur, notamment pour des installations servant à évacuer la chaleur résiduelle d'engins spatiaux, dispositif se présentant sous la forme d'une unité de vaporisation (1) comprenant au moins un élément de vaporisation dont la chambre à liquide et la chambre à vapeur sont séparées l'une de l'autre par un élément séparateur de type capillaire, et la chambre à vapeur qui se présente sous la forme de canaux primaires (24, 34-36) prévus le long d'un élément séparateur (26, 31) de forme tubulaire, dispositif caractérisé en ce qu'à la surface des parois (25) tournées vers l'élément séparateur (26, 31, 32) sont prévus des canaux secondaires (27, 37, 38) qui communiquent avec les canaux primaires (24, 34-36) et sont sensiblement perpendiculaires à ceux-ci.

2. Dispositif selon la revendication 1, caractérisé en ce que les canaux secondaires (27, 37, 38) ont une forme de spirale.

3. Dispositif selon la revendication 1 ou 2, caractérisé en ce que les canaux primaires (24) sont délimités par des entretoises (25a), des segments de tubes (25b) et des segments de parois (25c), tubulaires, ces derniers formant un tube intérieur (25) entourant concentriquement l'élément séparateur (26).

4. Dispositif selon la revendication 3, caractérisé par un tube profilé (22) à ailettes sur la surface extérieure du tube intérieur (25).

5. Dispositif selon la revendication 4, caractérisé en ce que le tube profilé (22) est entouré par un tube extérieur (21) à une certaine distance du tube profilé, et en ce que le volume entre le tube extérieur (21) et le tube profilé (22) est rempli d'un second fluide de travail.

6. Dispositif selon la revendication 5, caractérisé en ce que le tube extérieur (21) présente une section hexagonale.

7. Dispositif selon la revendication 6, caractérisé en ce que plusieurs éléments de vaporisation (12) sont réunis pour former une unité de vaporisation (10) qui comporte des orifices d'entrée (13, 17) et de sortie (15, 19) communs à tous les éléments de vaporisation (12) pour le premier fluide à évaporer (13, 15) et le second fluide de travail (17, 19).

8. Dispositif selon la revendication 1 ou 2, caractérisé en ce qu'au moins deux éléments de vaporisation sont réunis pour constituer une unité de vaporisation (30) en forme de plaque.

9. Dispositif selon la revendication 1 ou 2, caractérisé en ce que l'élément séparateur capillaire (26, 31, 32) est réalisé en métal pour créer un effet de pompe capillaire.

10. Dispositif selon la revendication 1 ou 2, caractérisé en ce que l'élément séparateur capillaire (26, 31, 32) est réalisé en matière synthétique telle que du PTFE pour créer une force de rappel capillaire.

11. Dispositif selon la revendication 1 ou 2, caractérisé en ce que l'élément séparateur capillaire (26, 31, 32) est revêtu, du côté exposé à la vapeur, d'une matière synthétique telle que du PTFE pour créer une force de rappel capillaire.

EP 0 334 142 B1

Fig. 1

Fig. 2

Fig. 3

Fig. 4

Fig. 5

Fig. 6

Fig. 7